# EUROPEAN PATENT APPLICATION

(11) **EP 4 366 168 A1**
(43) Date of publication of application: **08.05.2024**
(21) Application number: 22205382.9
(22) Date of filing: 03.11.2022
(51) Int. Cl.: H03K 17/12, H03K 17/28, H03K 17/00

(54) **CONTROLLER FOR AND CONTROL OF MULTI-SEGMENT SEMICONDUCTOR SWITCHES**

(71) Applicant: NXP B.V., 5656 AG Eindhoven (NL)
(72) Inventor: EFFING, Hermanus Johannes, 5656AG Eindhoven (NL)
(74) Representative: Hardingham, Christopher Mark

(57) **Abstract**

A controller (310) for a semiconductor switch having a plurality of switch segments and associated method are disclosed, the controller comprising: an input (130) configured to receive a succession of activation commands; an output (140) configured to, in response to each activation command, sequentially activate one or more of the segments in an output sequence; and an update unit (360) configured to modify the output sequence between activation commands. The output sequence may be modified deterministically, such as by cyclic rotation of the sequence, or stochastically, such as by random reordering of the elements of the sequence.

## Description

### Field

The present disclosure relates to methods of control of multi-segment semiconductor switches, and controllers therefor.

### Background

Semiconductor power switches are often implemented as a number of smaller, parallel connected, switch segments. When the power switch is activated (or deactivated), the switch segments are typically activated (and deactivated) in sequence rather than all at once. This may be particularly useful, for example, where it is desired to shape the turn-on and turn-off behaviour of the power switch, to spread peak currents from switch control drivers, or to modulate the switch impedance. Since the loading on the segments may vary during the start-up sequence, the ageing effect on the segments may vary between segments; for example the first segment to be activated may encounter higher load of stress conditions than the last segment to be activated. This may be undesirable.

### Summary

According to a first aspect of the present disclosure, there is provided a controller for a semiconductor switch having a plurality of switch segments, the controller comprising: an input configured to receive a succession of activation commands; an output configured to, in response to each activation command, sequentially activate one or more of the segments in an output sequence; and an update unit configured to modify the output sequence between activation commands. By modifying the output sequence between activation commands, it may be possible to even out the loading associated with early start-up on each segment, thereby reducing degradation in and potentially prolonging the useful life of the multi-segment switch. The output sequence may be modified between each (and every) successive activation command of the succession of activation commands, or periodically, for example it may be modified after a predetermined number of activation commands of the succession of activation commands. In embodiments, sequentially activating one or more of the segments in an output sequence corresponds to activating all of the segments in the output sequence. However, according to one or more other embodiments the output sequence does not include the entirety of the segments.

In one or more embodiments, the controller further comprises: a switch network, configured to receive a same input sequence in response to each of the succession of activation commands, and to generate the output sequence according to a switch map; wherein the update unit is configured to update the switch map between successive activation commands. According to such embodiments, the input sequence is fixed and does not vary between activation commands.

In one or more such embodiments the switch map is configured to produce the output sequence by a cyclic rotation of the input sequence. Cyclic rotation of the input sequence to result in an output sequence which changes upon each activation, or periodically after a predetermined number of activations, may provide a particularly convenient method of ensuring distribution of the initial start-ups over the segments of the multi-segment switch. In one or more embodiments the update unit is configured to update the switch map by increasing the rotation of the cyclic rotation.

In one or more embodiments the update unit comprises a counter unit configured to count the activation commands, and the switch map corresponds to a cyclic rotation of the input sequence, by the count of activation commands. Such a counter may be convenient for implementing cyclical rotation. In one or more embodiments, the controller may include a pre-divider operative with the counter such that the counter changes only after a predetermined number of activation commands; this may have the effect of reducing the speed of the cyclic rotation. That is to say the cyclic rotation changes only after the predetermined number of activation commands, and is invariant in between.

According to one or more other embodiments, the input sequence and the output sequence each comprise elements, and the switch map is configured to randomly assign elements of the input sequence to elements of the output sequence. According to one or more such embodiments the update unit is configured to update the switch map by randomly reassigning elements of the input sequence to elements of the output sequence. Over a large number of activations, randomly assigning the elements of the input sequence to elements of the output sequence will result in an even distribution of the start-up loading on the switch segments, according to the so-called law of large numbers. The random assignment may be changed every activation command, or only after a predetermined number of activation commands.

According to one or more embodiments the activation command comprises respectively an, or the, input sequence. Such embodiments may be designed to work with a separate switch control sequencer to generate an initial (input) sequence. The separate switch control sequencer may be implemented in hardware or software, and may be integrated into the same device as one or more parts of the controller, or may be separate therefrom.

According to one or more other embodiments, the controller itself comprises the switch control sequencer configured to generate a same input sequence in response to each of the succession of activation commands. That is to say, in such embodiments, the input sequence is invariant.

Alternatively, according to one or more other embodiments the controller may include a direct sequencer, configured to generate a respective output sequence in response to each activation command. Such embodiments may not require the generation of an input sequence; rather, the direct sequencer may be configured to generate the output sequence, corresponding to a stored sequence or otherwise.

According to one or more such embodiments, the update unit is configured to update the stored sequence between successive activation commands.

According to one or more embodiments the stored sequence may comprise a plurality of elements, and the update unit may then be configured to update the stored sequence by cyclically rotating the elements.

According to one or more other embodiments, the stored sequence may comprise a plurality of elements, and the update unit may then be configured to update the stored sequence by randomly reassigning the elements.

According to a second aspect of the present disclosure, there is disclosed a method of activating a power switch having a plurality of switch segments, the method comprising; receiving a succession of activation commands; in response to each activation command, sequentially activating one or more of the segments in an output sequence; and modifying the output sequence between each successive activation command. The method may comprise, for each activation command: receiving a same input sequence in a switch network, and generating the output sequence according to a switch map in the switch network. Modifying the output sequence may comprise cyclically rotating a mapping of the input sequence to the output sequence. Alternatively, and without limitation, the input sequence and the output sequence may each comprise elements, and modifying the output sequence may then comprise randomly assigning elements of the input sequence to elements of the output sequence. Modifying the output sequence between each successive activation command may comprise randomly reassigning elements of the input sequence to elements of the output sequence. The method may further comprise generating, by means of a switch control sequencer a same input sequence in response to each of the succession of activation commands.

There may be provided a computer program, which when run on a computer, causes the computer to configure any apparatus, including a circuit, controller, sensor, filter, or device disclosed herein or perform any method disclosed herein. The computer program may be a software implementation, and the computer may be considered as any appropriate hardware, including a digital signal processor, a microcontroller, and an implementation in read only memory (ROM), erasable programmable read only memory (EPROM) or electronically erasable programmable read only memory (EEPROM), as nonlimiting examples. The software implementation may be an assembly program.

The computer program may be provided on a computer readable medium, which may be a physical computer readable medium, such as a disc or a memory device, or may be embodied as another non-transient signal.

These and other aspects of the invention will be apparent from, and elucidated with reference to, the embodiments described hereinafter.

### Brief description of Drawings

Embodiments will be described, by way of example only, with reference to the drawings, in which
FIG. 1 illustrates a conventional segmented switch control sequencer for controlling a multi-segment switch;
FIG. 2 shows a sequence of individual segment activation controls for the sequencer of figure 1;
FIG. 3 illustrates a multi-segment switch, and a controller according to one or more embodiments;
FIG. 4 shows the multi-segment switch, and controller according to one or more embodiments of FIG 3 in more detail;
FIG. 5 illustrates a multi-segment switch, and a controller according to one or more other embodiments;
FIG. 6, FIG 7a, FIG. 7b and FIG. 7c, illustrate operation of a controller such as that shown in FIG. 4 over three consecutive activations;
FIG. 8 shows sequences of individual segment activation controls, across three activations, for a controller according to one or more embodiments;
FIG. 9 shows sequences of individual segment activation controls, across three activations, for a controller according to other embodiments;
FIG. 10 shows sequences of individual segment activation controls, across three activations, for a controller according to other embodiments; and
FIG. 11 shows sequences of individual segment activation controls, across five activations, for a controller according to other embodiments.

It should be noted that the figures are diagrammatic and not drawn to scale. Relative dimensions and proportions of parts of these figures have been shown exaggerated or reduced in size, for the sake of clarity and convenience in the drawings. The same reference signs are generally used to refer to corresponding or similar features in modified and different embodiments

### Detailed description of embodiments

As mentioned above, segments of a multi-segment semiconductor switch such as a power switch may be activated or deactivated according to a sequence. Multiple repetitions of the activation according to the same sequence may result in different stress conditions applying to different segments, which in turn may affect the ageing of the segments. Typically, the switch segments activated first are subject to worse operating conditions such as higher inrush currents or higher initial voltages across the switch than are the switch segments activated last. The first activated segments may turn-on under worse "hot carrier biasing" conditions and may see a higher drain source voltage (V_{DS}) whilst they are turning on.

According to the present disclosure, methods and apparatus are proposed which may reduce or ameliorate the effects of the switch segment activation order. In particular, it is proposed to vary the order, or sequence, in which the switch segments are activated. This may be done either deterministically or stochastically.

According to deterministic methods, the activation sequence is adjusted between each activation according to a predetermined adjustment criterion. For example, the order of activation of the switch segments may be cyclically rotated, such that, over time, each switch segment is the first to be activated with an equal, or approximately equal, frequency.

According to stochastic methods, the activation sequence may be randomised. In each activation event, the first segment to be activated is selected according to a random or pseudo-random function. Similar to deterministic methods, over a large number of activations, each switch segment will be the first to be activated with an approximately equal frequency.

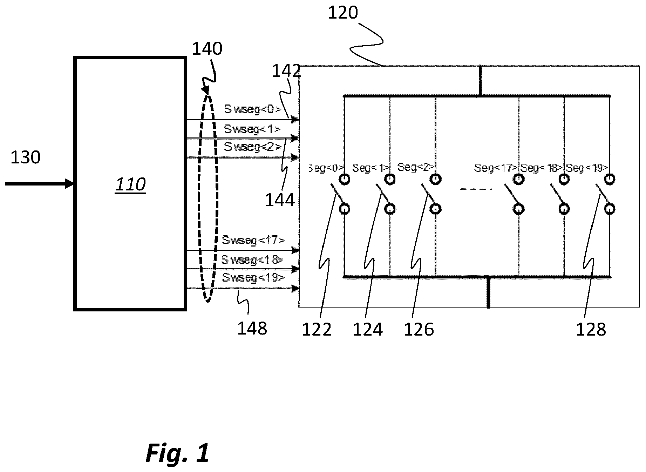

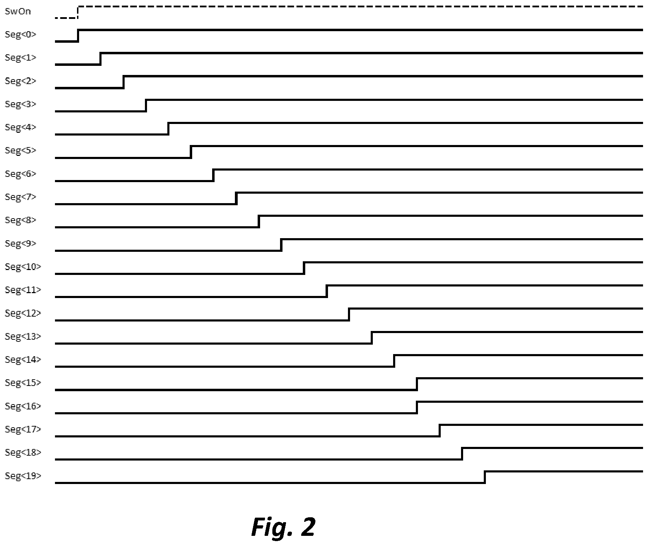

Turning now to the figures, FIG. 1 shows a conventional segmented switch control sequencer 110 for controlling a multi-segment switch 120. The multi-segment switch 120 is a switch having a plurality of switch segments Seg<0> 122, Seg<1> 124, Seg<2> 126, and so on, in this case up to Seg<19> 128. The segmented switch control sequencer 110 receives, at an input 130, a switch-on signal, which may also be referred to as an activation command. It includes an output 140 comprising a plurality of control lines for controlling the individual segments. The control lines each provide an activation signal for a respective segment. In particular, a first control line 142 provides a signal Swseg<0> to turn on the control segment Seg<0> 122, the second control line 144 provides a signal Swseg<1> to control the second segment Seg<0> 124, and so on. As illustrated in FIG. 2, on receipt of a switch-on signal or activation command at input 130, the segmented switch control sequencer 110 immediately puts the signal Swseg<0> on the first control line 142 high to turn-on, or activate, the first switch segment 122. Thereafter, typically after a short delay which may be of the order of 100s ps or a few ns it puts the signal Swseg<1> on the second control line 144 high to turn-on, or activate, the second switch segment 124, and so on, until finally its puts the signal-high on the control line for the last segment - in this example Swseg<19> on the last control line 148 - to turn on or activate the last switch segment Seg<19> 128.

Each time the switch is activated by input signal 130, the switch segments are turned on or activated in the same sequence. The stress on the first segment 122 is thus significantly worse than that on the last segment 128, leading to potentially differential ageing effects. It can be expected that switch segment 122 will fail first because of the relatively accelerated ageing effects relative to the other segments. The lifetime of the multi-segment switch 120 is controlled by the weakest component, and thus the lifetime of the switch is limited by that of segment 122.

Embodiments of the present disclosure may improve the ageing of the device, by more uniformly distributing the stress across the switch segments, by modifying, over time, the turn-on sequence of the segments.

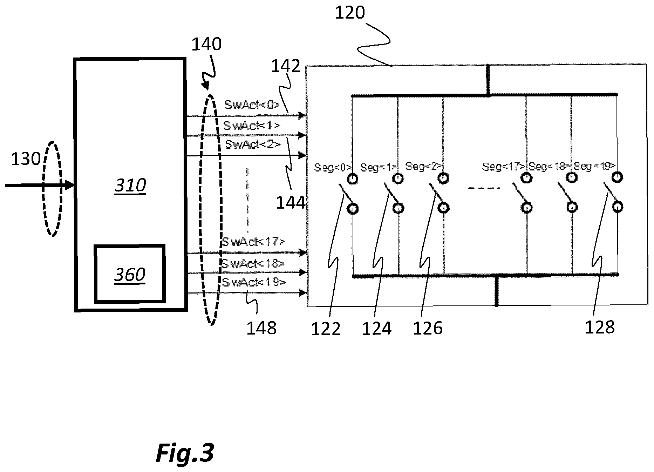

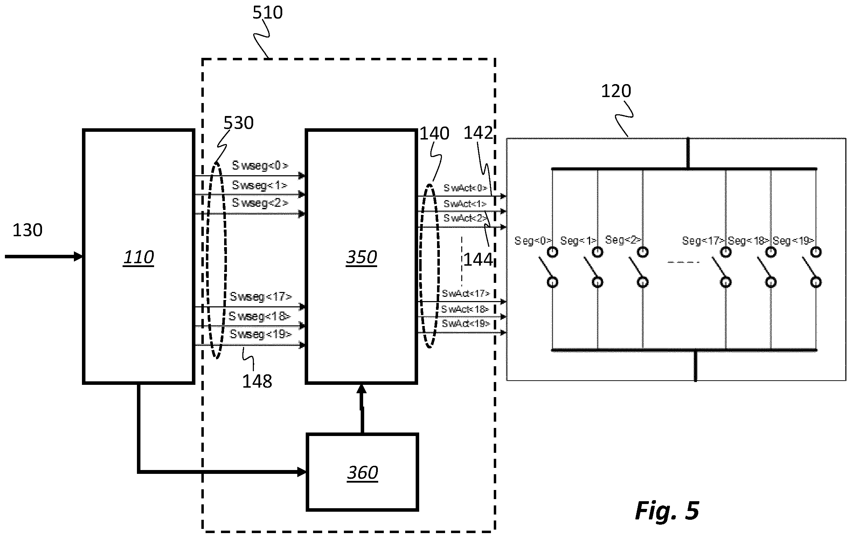

FIG. 3 illustrates a multi-segment switch 120, and controller 310 according to one or more embodiments. The controller comprises an input 130 configured to receive a succession of activation command. Each activation command may be a single switched signal on a single line input (such as that shown in figure 3) or may be a plurality of switched signals such as will be discussed hereinbelow having regard to FIG. 5. The controller further comprises an output 140 which is configured to, in response to receiving the activation command, sequentially activate the segments of the multi-segment switch according to an output sequence - that is to say, in a specific order. For a first activation the sequence may be the same as that described above with respect to FIG.s 1 and 2, however, as will become evident from the present disclosure, for a second activation command or subsequent activation command, the sequence will in general be different. As a result, the turn-on order of the segments is in general different for the second activation than from the first activation, and in the third activation it will be again be different from those of each of the first activation and the second activation. The skilled person will appreciate that between each activation command to turn on the switch and the individual elements or segments of the switch, the segments are generally switched off. In general, the sequence of switching off, or deactivating, the elements may be periodically cycled, or randomised, for example in the same fashion is the turn-on sequence, in order to average out any voltage spikes or other stresses at turn-off. For example, the sequence of the turnoff of the segments may be the same, or the inverse of, the sequence of turn on of the segments. Since the turn on sequence is correctly changed, for example by cycling either on each activation or after a predetermined number of activations or by randomisation, as discussed above, the turnoff sequence will thus also change over time, averaging the stress on the individual segments. Furthermore, as will be considered in more detail hereinbelow, In some embodiments not all of the segments need be switched off or deactivated. In such embodiments the reactivation of only some of the segments may be cyclically rotated or randomised, whilst one or more of the segments may remain activated.

In order to ensure that the activation sequence of the segments - that is to say the output sequence - for the second activation (or other subsequent activation) differs from that of the first activation, the controller includes an update unit 360. As will become clearer hereinbelow, the update unit may take a variety of forms.

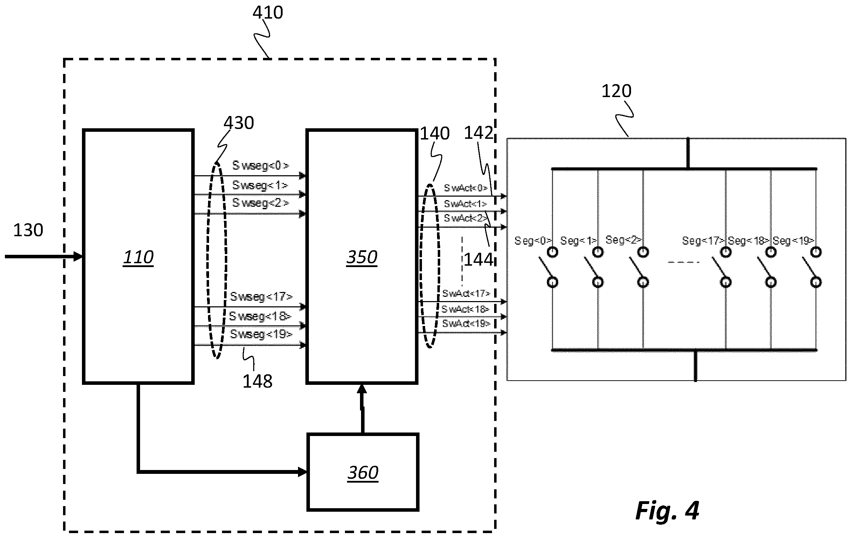

Turning now to FIG. 4, this illustrates a multi-segment switch 120, and a controller 410 according to one or more embodiments. The controller 410 includes a switch control sequencer 110, which receives, at an input 130, the activation command to turn on the switch. The switch control sequencer 110 has an output 430 which may, as shown, consist of a plurality of control lines, one control line for each of the N switch segments, that is to say Swseg<0>, Swseg<1>... Swseg<N-1>, where in this case N is 20. In response to an activation command at the input 130, the switch control sequencer 110 produces a sequence of logical-segment-activation commands, such as the signals Swseg<0>, Swseg<1>, ... described with respect to FIG. 2. Thus, on receipt of a switch-on signal or activation command at input 130, the segmented switch control sequencer 110 puts the signal Swseg<0> on the first control line 142 high to turn-on, or activate, the first switch segment 122. Thereafter, it puts the signal Swseg<1> on the second control line 144 high to turn-on, or activate, the second switch segment 124, and so on, until finally its puts the signal-high on the control line for the last segment - in this example Swseg<19> on the last control line 148 - to turn on or activate the last switch segment Seg<0> 128. This sequence is fixed (Swseg<0> → Swseg<1> → Swseg<2> → ... →Swseg<19> in the example shown with 20 segments, and is repeated for any subsequent activations of the switch segments according to subsequent activation commands at input 130. However, in general this is not the sequence in which the segments are actually activated, as will now be explained.

Controller 410 includes a switch network 350. Switch 350 has the function of rearranging the sequence. It may do this according to a switch map, which changes from time to time. The sequence output by the switch control sequencer 110 on output 430 may be also described as an input sequence (on an input, in this case a multi-control line input) since it is an input to the switch network 350. Switch network 350 also has an output 140, which may, as shown consist of individual control lines, one for each switch segment. The signal on these output control lines may be termed SwAct<i>, with i from 0 to N-1, as shown. Thus signal SwAct<0> controls the segment Seg<0>, SwAct<1> controls the segment Seg<1>, and so on up to SwAct<N-1> which controls the segment Seg<N-1> (in the example shown, this is SwAct<19> which controls the segment Seg<19>. The switch network 350 rearranges the input sequence to result in the output sequence by mapping the individual input control lines to individual output control lines:
1. Swseg<i> → SwAct<j>.

In general, i is not equal to j. As will be discussed in more detail hereinunder, one simple, convenient mapping, is a cyclic rotation:
1. Swseg<i> → SwAct<((i+x-1)MOD_{N})> ,
where x represents the x-th activation command, and pMODn, means "p, modulo n". The skilled person will appreciate that other mappings are equally possible.

Controller 410 further includes an update unit 360. In the above example of cyclic rotation, update unit 360 may comprise a counter which keeps track of x by counting the number of activation commands received by the switch control sequencer 110. According to one or more other embodiments, the update unit 360 may further comprise a pre-divider configured and arranged with the counter such that the counter only updates after a pre-division factor f. In such embodiments, the cyclic rotation may be defined through:
i. Swseg<i> → SwAct< ((i+INT(x/f)-1) MOD_{N})>.

FIG. 5 illustrates a multi-segment switch, and controller 510 according to other embodiments of the present disclosure. The overall architecture is similar to that described with respect to FIG. 4 except that in this case, the controller 510 does not include the switch control sequencer 110. In embodiments such as that shown in FIG. 5, the input to the controller is the input 530, being the output from the switch control sequencer 110. Whereas in embodiments such as that shown in FIG. 4 the activation command may consist of a single change of state (such as low to high) of a signal on input 130, in embodiments such as that shown in FIG. 5, the activation command may consist of a sequence. The sequence may also referred to as an input sequence, since it is input to the controller 510. The sequence may, as shown, consist of the order of change of states of signals Swseg<0>, Swseg<1>, ... <Swseg<N-1>.

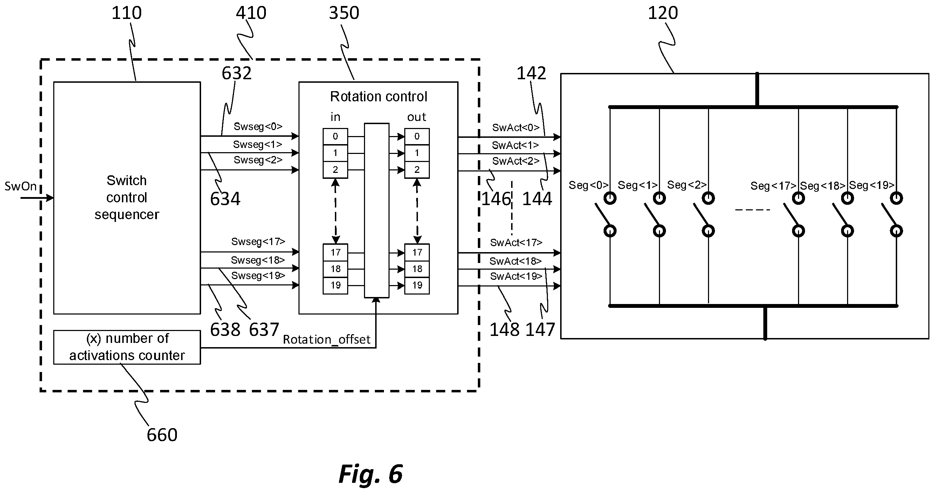

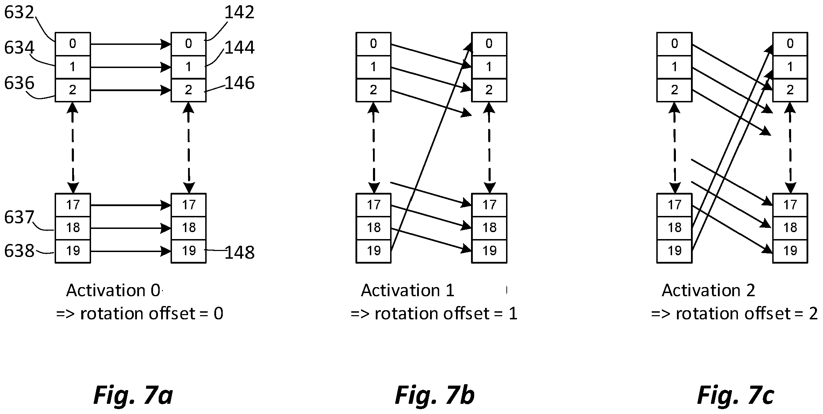

FIG. 6, together with FIG. 7a, FIG. 7b, and FIG. 7c, illustrates operation of embodiments such as that described above with respect to FIG. 4. Update unit 360 is implemented here as a counter 660 which counts the number of activations. Operation of the switch network 350 is shown in detail, for the first activation ("Activation 0"), in FIG. 7a: the switch network switches the input line 632 carrying signal Swseg<0> to the to the output, or control, line 142 carrying signal SwAct<0>. Similarly it switches the input line 634 carrying signal Swseg<1> to the to the output, or control, line 144 carrying signal SwAct<1>, and so on for each of the lines which are switched to the corresponding output line.

Operation of the switch network in a second activation ("Activation 1") is illustrated in FIG.7b: the switch network switches the input line 632 carrying signal Swseg<0> to the second output, or control, line 144 carrying signal SwAct<1>. Similarly, it switches the input line 634 carrying signal Swseg<1> to the output, or control, line 146 carrying signal SwAct<2>, and so on up to the last-but-one input line 637 carrying signal Swseg<18> to the output, or control, line 148, carrying signal SwAct<19>. However, the last input line 638 carrying signal Swseg<19> is switched to the output, or control, line 142 carrying signal SwAct<0>. The mapping in this activation is rotation by 1.

Operation of the switch network in a third activation ("Activation 2") is illustrated in FIG. 7c: the switch network switches the input line 632 carrying signal Swseg<0> to the output, or control, line 146 carrying signal SwAct<2>. Similarly it switches the input line 634 carrying signal Swseg<1> to the output line carrying signal SwAct<3>, and so on up to the last-but-two input line carrying signal Swseg<17> to the output , or control, line 148 carrying signal SwAct<19>. However, the last-but one input line 637 carrying signal Swseg<18> is switched to the output line 142 carrying signal SwAct<0>, and the last input line 638 carrying signal Swseg<19> is switched to the output, or control, line 144 carrying signal SwAct<1>. The mapping in this activation is rotation by 2.

It will be readily appreciated that the rotation continues for subsequent activations. After 20 activations ("Activation 19"), the cyclic rotation has gone round one complete cycle so the "Activation 20" mapping will correspond to that for "Activation 0", the "Activation 21" mapping will correspond to that for "Activation 1", and so on.

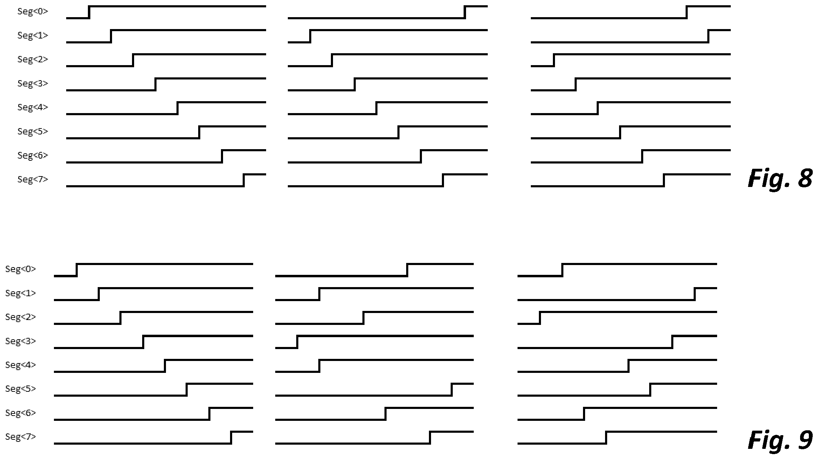

The control signals which activate individual segments (Seg <0>, Seg <1>... Seg<7>), on the first three activations are shown in FIG. 8 left hand, centre, and right-hand side respectively, in each case plotted against time on the x-axis. This nonlimiting example is for a multi-segment switch having eight segments. The cyclic nature of the reordering of the control is immediately apparent. The skilled person will recognise that, using matrix terminology, the mapping of the first activation corresponds to an identity matrix; subsequent activations correspond to cyclic rotation of the columns (or rows) of the matrix.

FIG. 9 illustrates an alternative way of changing, or modifying, the mapping over a first three activations. In this example, mapping for the first activation (shown on the left-hand-side) is a simple "unity" one-to-one mapping (input line 1 → output line 1, input line 2 → output line 2, etc). Using matrix algebra terminology, this corresponds to an identity matrix. The centre section shows the mapping for a second activation: the sequence, or order in which the segments are activated is random. The right section shows the mapping for a third activation: the sequence or order in which the segments are activated is again random, and generally different to that shown in the second activation. Of course, the skilled person will recognise that the mapping is not entirely random, since each input line has to be mapped to a different output control line; using matrix algebra terminology, this corresponds to a permutation matrix which defines a sequence, in which the position of the non-zero element of each row may be considered an element of the sequence. As already mentioned above, the modification of the mapping may occur after each and every activation, or after a predetermined number of activations has occurred. In general, the predetermined number of activations will be constant over time, in order to maximise the smoothing effects over the segments. For example, the mapping may be modified after every 5 activations, or after every 20 activations. However, the skilled person will appreciate that the predetermined number of activations may be allowed to vary over time, provided only that the segments are activated a sufficient number of times for an appreciable level of smoothing to occur even with a randomisation of the predetermined number.

In order for the switch network 350 to implement such a randomisation of the sequence, the update unit 360 may comprise a random number generator in such embodiments.

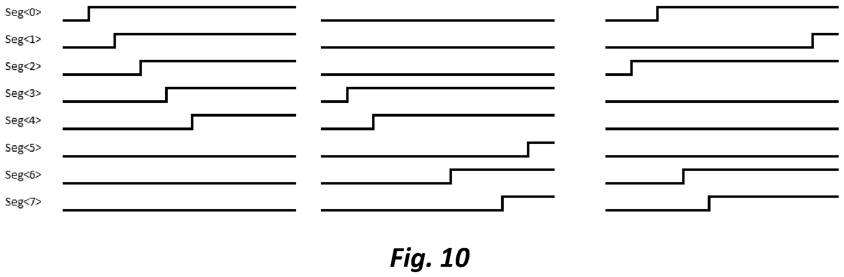

Turning now to FIG. 10, this illustrates the activation signals for individual segments according to other embodiments of the present disclosure. In this example, the multi-segment switch is not required to be completely activated - that is to say not all of the segments in the switch are required to be turned on. This may be the case, when the switch is not required to have a particularly low Rds-on ("on-resistance"), or to control or pass a very high current level. In general this may be relevant when a larger switch than strictly necessary, or an "over-specification" switch is used. It may be designed into the application, or may occur during some but not all operations of the application. Various techniques may be employed to make the decision whether to activate only a subset of the segments, for example, the switch and may be considered as a digital to analog converter (DAC), in which activating each segment corresponds to converting a quantum ("digit") of the digital signal to a corresponding analog signal component. The equivalent "analog" number of switch seqments is remapped on the total number of switch segments as illustrated in FIG. 10.

The left-hand side of FIG. 10 illustrates the activation signals for the interval said segments on a first activation, in which it is determined that only a subset of the segments require activation - in example shown only five segments (Seg<0>, Seg<1>... Seg<4>) out of an available eight segments are required to be activated. For a first activation the sequence may be simply Seg<0>, Seg<1>, Seg<2>, Seg<3>, Seg<4>) as shown; the final three segments Seg<5>, Seg<6>, Seg<7> remain unactivated. In order to balance the stress across all the segments, over a large number of activations, it is necessary to, on some occasions, activate these last three segments, Seg<5>, Seg<6>, Seg<7>. This may be done as illustrated in centre section of FIG.10 in which, during a second activation ("Activation 1"), the first three segments (Seg<0>, Seg<1>, Seg<2>) are excluded by cyclically rotating the un-activated group. Then, for the next activation, the excluded segments may be cyclically rotated again such that (Seg<3>, Seg<4>, Seg<5>) are left un-activated. It will be appreciated that over time, the un-activated segments are balanced.

This technique may be combined with either cyclic rotation of the activated segments or, as shown in FIG. 10, randomisation of the sequence of activation of those segments which are included in the group to be activated.

Figure 10 illustrates a situation in which between individual activation commands, all of the activated segments are deactivated. Accordingly, such embodiments typically comprise a controller wherein the output 140 is configured to, in response to each activation command, sequentially activate all of the segments in an output sequence.

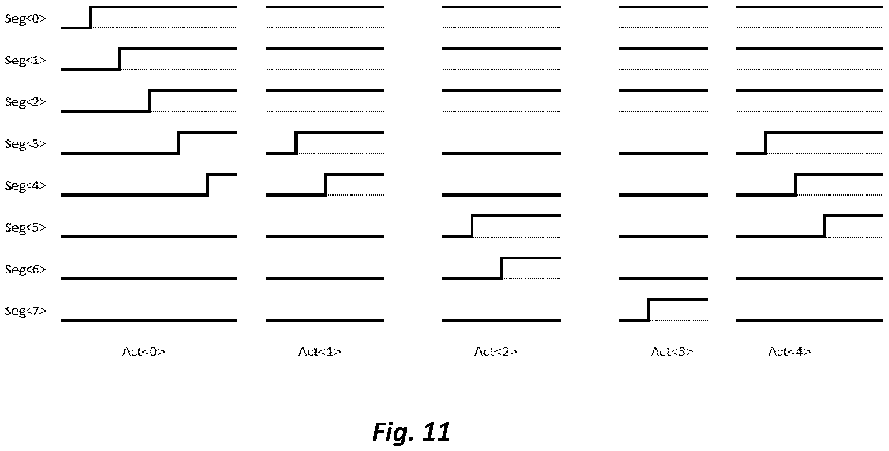

However, according to other embodiments, one or more of the segments may remain activated whilst others of the segments are deactivated. Such embodiments comprise a controller wherein the output 140 is configured to, in response to each activation command, sequentially activate one or more, but fewer than all, of the segments in an output sequence. Operation of such controller is illustrated in FIG. 11.

FIG. 11 shows sequences of individual segment activation controls, across 5 activations, for a controller according to other embodiments. Embodiments such as that illustrated in figure 11 may incorporate the so-called DAC functionality as discussed above. In such embodiments, between individual activations, not all of the segments need be de-activated. This is illustrated in FIG. 11, in which during a first activation, Act<0>, it is determined that five of the segments are required to be activated. Thereafter, it is determined that only three of the segments are required, so instead of deactivating all of segments, only two of the segments (Seg<3> and Seg<4>) are deactivated and three of the segments (Seg<0>, Seg<1> and Seg<2>) remain activated. On the next activation command (Act<1>), it is determined that, once again, five segments are required and as a result Seg<3> and Seg<4>) are (re)-activated. Thereafter, only three segments are required so Seg<3> and Seg<4> are deactivated. For the next activation command, (Act<2>), it is determined that, once again, five segments are required; however, the output sequence has now been modified (in this nonlimiting example by cyclic rotation), and as a result Seg<5> and Seg<6>) are activated. On the next activation it is determined that four segments (in total) are required. The output sequence has again been modified (again by cyclic rotation), so for this activation command (Act<3>), Seg<7> is activated, according to the - modified - output sequence. Finally shown is the following activation, for which a total of six segments are required, Seg<3>, Seg<4> and Seg<5> are activated according to the again-modified output sequence.

The skilled person will readily appreciate that although FIG. 5, shows an application in which three segments (Seg<0>, Seg<1> and Seg<2>) remain activated, in other applications a varying number of segments may be activated and deactivated. Moreover, whereas the embodiments shown in figure 5 illustrates cyclic rotation of a varying number of the segments, in other embodiments, the modification may be random reallocation of segments for activation.

Embodiments of the present disclosure relate to the sequencing of activation of individual segments of the multi-segment switch. However the segments may be further subdivided into sub segments. From one viewpoint, groups of sub-segments may be simultaneously activated (through the activation of "a segment"); conversely, it will be appreciated that from another viewpoint the individual segments may correspond to the sub-segments just mentioned such that in the above discussion activation of a "segment" corresponds to activation of a group of the individual segments.

The term "control" and "control lines" as used in hearing should be interpreted broadly. In particular they may be used, as appropriate, to refer to a digital signal for passing information, or to a signal capable of delivering sufficient power to, for instance driving the gate of a switch or switch segment, or the gate of a transistor or a transistor segment.

From reading the present disclosure, other variations and modifications will be apparent to the skilled person. Such variations and modifications may involve equivalent and other features which are already known in the art of controlling multi-segment switches and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

It is noted that one or more embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Features which are described in the context of separate embodiments may also be provided in combination in a single embodiment. Conversely, various features which are, for brevity, described in the context of a single embodiment, may also be provided separately or in any suitable sub-combination.

For the sake of completeness it is also stated that the term "comprising" does not exclude other elements or steps, the term "a" or "an" does not exclude a plurality, a single processor or other unit may fulfil the functions of several means recited in the claims [delete if not relevant] and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to.

### List of Symbols:

- 110: segmented switch control sequencer
- 120: multi-segment switch
- 122: Seg<0>
- 124: Seg<1>
- 126: Seg<2>
- 128: Seg<19>
- 130: input
- 140: output
- 142: first control line
- 144: second control line
- 146: third control line
- 148: last control line
- 310: controller
- 350: switch network
- 360: update unit
- 410: controller
- 430: input
- 510: controller
- 530: input
- 632: first input line
- 634: second input line
- 637: last-but-one input line
- 638: last input line
- 660: counter

## Claims

1. A controller (310) for a semiconductor switch having a plurality of switch segments, the controller comprising:
an input (130) configured to receive a succession of activation commands;
an output (140) configured to, in response to each activation command, sequentially activate one or more of the segments in an output sequence;
and an update unit (360) configured to modify the output sequence between activation commands.

2. The controller according to claim 1 wherein the output is configured to, in response to each activation command, sequentially activate all of the segments in an output sequence.

3. The controller according to claim 1 or 2, further comprising:
a switch network (350), configured to receive a same input sequence in response to each of the succession of activation commands, and to generate the output sequence according to a switch map;
wherein the update unit is configured to update the switch map between activation command.

4. The controller according to claim 3 wherein the switch map is configured to produce the output sequence by a cyclic rotation of the input sequence.

5. The controller according to claim 4, wherein the update unit is configured to update the switch map by increasing the rotation of the cyclic rotation.

6. The controller according to claim 4 or 5, wherein the update unit comprises a counter unit (660) configured to count the activation commands, and the switch map corresponds to a cyclic rotation of the input sequence, by the count of activation commands.

7. The controller according to claim 3, wherein the input sequence and the output sequence each comprise elements, and the switch map is configured to randomly assign elements of the input sequence to elements of the output sequence.

8. The controller according to claim 7, wherein the update unit is configured to update the switch map by randomly reassigning elements of the input sequence to elements of the output sequence.

9. The controller according to any of claims1 or 2, or any of claims 3 to8, wherein each activation command comprises respectively an, or the, input sequence.

10. The controller according to any of claims 3 to 8, further comprising a switch control sequencer (110) configured to generate a same input sequence in response to each of the succession of activation commands.

11. The controller (410) according to claim 1 or 2, further comprising a direct sequencer (110), configured to generate a respective output sequence in response to each activation command.

12. The controller according to claim 11, wherein the direct sequencer is configured to generate the output sequence corresponding to a stored sequence.

13. The controller according to claim 12, wherein the update unit is configured to update the stored sequence between activation commands.

14. The controller according to claim 13, wherein the stored sequence comprises a plurality of elements, and the update unit is configured to update the stored sequence by cyclically rotating the elements.

15. A method of activating a power switch having a plurality of switch segments, the method comprising;
receiving a succession of activation commands;
in response to each activation command, sequentially activating one or more of the segments in an output sequence; and
modifying the output sequence between activation commands.
